(19) Europäisches Patentamt

European Patent Office

Office européen des brevets

(11) **EP 1 072 664 B1**

(12) **EUROPEAN PATENT SPECIFICATION**

(45) Date of publication and mention
of the grant of the patent:
**01.10.2003 Bulletin 2003/40**

(51) Int Cl.[7]: **C09J 7/02**

(21) Application number: **00115791.6**

(22) Date of filing: **21.07.2000**

(54) **Adhesive sheets**

Klebefolien

Feuilles adhésives

(84) Designated Contracting States:
**BE DE FR GB IT NL**

(30) Priority: **29.07.1999 JP 21482899**

(43) Date of publication of application:
**31.01.2001 Bulletin 2001/05**

(73) Proprietor: **NITTO DENKO CORPORATION**
**Osaka (JP)**

(72) Inventors:
  • **Muta, Shigeki, c/o Nitto Denko Corporation**
  **Ibaraki-shi, Osaka (JP)**

• **Yamamoto, Hiroshi, c/o Nitto Denko Corporation**
**Ibaraki-shi, Osaka (JP)**

(74) Representative: **Grünecker, Kinkeldey,**
**Stockmair & Schwanhäusser Anwaltssozietät**
**Maximilianstrasse 58**
**80538 München (DE)**

(56) References cited:
**EP-A- 0 454 426        EP-A- 0 697 484**

• **PATENT ABSTRACTS OF JAPAN vol. 018, no.**
**562 (C-1265), 27 October 1994 (1994-10-27) & JP**
**06 200500 A (TOMOEGAWA PAPER CO LTD), 19**
**July 1994 (1994-07-19)**

**Description**

FIELD OF THE INVENTION

This invention relates to adhesive sheets which are useful in fixing flexible printed circuit boards (hereinafter referred to simply as FPCs), reinforcing plates thereof and the like. More particularly, it relates to adhesive sheets which do not undergo self-adhesion at the cut surface in case of being punched alone and which do not damage the cut surface of FPCs or reinforcing plates thereof in case of being adhered to the FPCs or reinforcing plates thereof and then punched.

BACKGROUND OF THE INVENTION

As adhesive tapes for fixing FPCs and reinforcing plates thereof, it has been a practice to use adhesive tapes consisting of a release liner made of paper alone or glassine paper provided with silicone layer(s) on one or both faces thereof or a release liner made of woodfree paper provided with polyethylene layer(s) on one or both faces and further provided with silicone layer(s) on one or both faces thereof and an acrylic pressure-sensitive adhesive layer provided thereon. Although the release liner made of paper alone or glassine paper provided with silicone layer(s) has excellent punching qualities, the paper per se has only a low dimensional stability and thus punched articles obtained therefrom are poor in dimensional accuracy. On the other hand, the release liner made of woodfree paper provided with polyethylene layer(s) on one or both faces and further provided with silicone layer(s) has a high dimensional accuracy of punched articles. When a tape of this type is adhered to a reinforcing plate of an FPC or the like and then punched, however, the cut surface of the reinforcing plate or the like is bored or cut-out and thus seriously damaged, particularly in case of a thick reinforcing plate or the like.

With the improvement in the performances of electronic components, the procedure of washing FPCs with pure water or washing water has spread from the viewpoint of preventing contamination. In this procedure, FPCs are frequently washed as having adhesive tapes with a release liner adhered thereto in order to improve the workability. In this procedure, a release liner merely made of glassine paper or paper alone provided with silicone layer(s) directly formed thereon absorbs moisture and thus suffers from a decrease in the adhesiveness due to the moisture adhered to the pressure-sensitive adhesive face. In serious case, the release liner (separator) is torn or undergoes interlayer breakage during the washing procedure.

When a conventional adhesive sheet is punched particularly under hot and highly moist conditions, the cut surface undergoes self-adhesion after punching and thus the workability is worsened. In the worst case, a pressure-sensitive adhesive is broken off in the step of separating punched articles.

SUMMARY OF THE INVENTION

Accordingly, an object of the invention is to provide adhesive sheets which do not undergo self-adhesion at the cut surface with the passage of time in case of being punched alone, which do not damage the cut surface of reinforcing plates or the like in case of being adhered to FPCs, reinforcing plates thereof or the like and then punched, and which do not suffer from release liner breakage due to moisture absorption in the washing procedure.

To achieve the above-described object, the inventors have made intensive studies. As a result, they have found out that the self-adhesion at the cut surface and damage of adherends at the punching step can be relieved and breakage during the washing procedure can be prevented by providing a specific layer on the surface of the paper base material of the release liner and using a specific acrylic pressure-sensitive adhesive as a constituent of the pressure-sensitive adhesive layer, thereby completing the invention.

Accordingly, the invention provides adhesive sheets having a laminated structure consisting of a release liner and a pressure-sensitive adhesive layer, wherein the above-described release liner consists of a paper base material, clay coat layers provided on both faces of the paper base material and silicone layer(s) provided on one or both faces of the clay coat layers, a pressure-sensitive adhesive constituting the above-described pressure-sensitive adhesive layer contains, as the main component, an alkyl (meth) acrylate-series copolymer comprising from 88 to 100% by weight of an alkyl (meth) acrylate carrying an alkyl group having 2 to 14 carbon atoms on average and from 0 to 12% by weight of a monoethylenic unsaturated monomer copolymerizable therewith, and the pressure-sensitive adhesive contains at least 70% of solvent-insoluble matters.

The invention further provides adhesive sheets having pressure-sensitive adhesive layer(s) on one or both faces of a base material wherein the pressure sensitive adhesive layer(s) are covered with release liner(s), wherein the above-described release liner consists of a paper base material, clay coat layers provided on both faces of the paper base material and silicone layer(s) provided on one or both faces of the clay coat layers, a pressure-sensitive adhesive constituting the above-described pressure-sensitive adhesive layer contains, as the main component, an alkyl (meth)acrylate-series copolymer comprising from 88 to 100% by weight of an alkyl (meth) acrylate carrying an alkyl group having 2 to 14 carbon atoms on average and from 0 to 12% by weight of a monoethylenic unsaturated monomer copolymerizable therewith, and the pressure-sensitive adhesive contains at least 70% of solvent-insoluble matters.

The term "solvent-insoluble matters" as used herein means matters which are insoluble in ethyl acetate after immersing a pressure-sensitive adhesive constituting the pressure-sensitive adhesive layer in ethyl acetate at room temperature for 1 week, expressed in the "ratio to the pressure-sensitive adhesive before the treatment (on the weight basis)".

BRIEF DESCRIPTION OF THE DRAWINGS

Fig. 1 is a sectional view showing an example of the adhesive sheets according to the invention.
Fig. 2 is a sectional view showing another example of the adhesive sheets according to the invention.

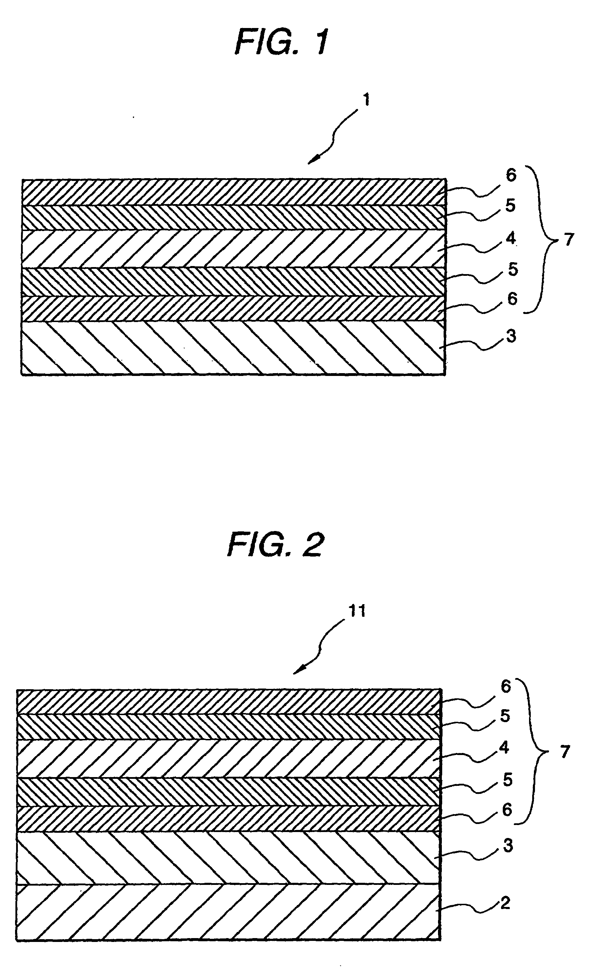

The symbols as described in Figs. 1 and 2 will hereinafter be explained.

1,11     : adhesive sheet.
2        : base material.
3        : pressure-sensitive adhesive layer.
4        : paper base material.
5        : clay coat layer.
6        : silicone layer.
7        : release liner.

DETAILED DESCRIPTION OF THE INVENTION

Next, modes for carrying out the invention will be described by reference to, if necessary, the attached drawings. Fig. 1 is a sectional view showing an example of the adhesive sheets according to the invention, while Fig. 2 is a sectional view showing another example of the adhesive sheets according to the invention.
In the example of Fig. 1, an adhesive sheet 1 has a laminated structure consisting of a release liner 7 and a pressure-sensitive adhesive layer 3. The above-described release liner 7 consists of a paper base material 4, clay coat layers 5 provided on both faces of the paper base material 4 and silicone layers 6 provided on both faces of the clay coat layers 5. In the example of Fig. 2, an adhesive sheet 11 has a pressure-sensitive adhesive layer 3 on one face of a base material 2 and the pressure-sensitive adhesive layer 3 is covered with a release liner 7 having the same layered constitution as described above. The silicone layer 6 may be provided on only one face (for example, the face in the pressure-sensitive adhesive layer side) of the clay coat layer 5. In Fig. 2, the pressure-sensitive adhesive layer 3 and the release liner 7 may be laminated on both faces of the base material 2.
The above-described pressure-sensitive adhesive layer 3 has, as the main component, an alkyl (meth)acrylate-series copolymer comprising from 88 to 100% by weight of an alkyl (meth)acrylate carrying an alkyl group having 2 to 14 carbon atoms on average and from 0 to 12% by weight of a monoethylenic unsaturated monomer copolymerizable therewith and containing at least 70% of solvent-insoluble matters.
Because of having the above-described constitution wherein the clay coat layers 5 are formed on both faces of the paper base material 4 and the pressure-sensitive adhesive layer 3 has a pressure-sensitive adhesive containing a specific component and at least a specific amount of solvent-insoluble matters, these adhesive sheets are not only excellent in the cut properties at the punching step and the dimensional accuracy of punched articles but also cause no damage on adherends in the punching step. In the procedure of washing (for example, ultrasonic washing) with pure water or washing water, moreover, these adhesive sheets can prevent the release liner from a decrease in the adhesiveness or breakage due to the moisture absorption by the release liner and relieve the self-adhesion at the cut surface of the adhesive sheets.
The paper base material 4 constituting the release liner 7 may be made of an arbitrary material without restriction. For example, use can be made of woodfree paper, glassine paper, Kraft paper, Krupack paper, etc. The thickness of the paper base material 4 ranges, for example, from 60 to 130 µm.
As the material of the clay coat layer 5 of the release liner 7, use may be made of ceramics, for example, inorganic oxides, hydroxides, carbonates, sulfates, silicates, titanates, borates, carbides, nitrides, borides, carbon, etc. Preferable examples of the ceramics include oxides such as silica and alumina and silicates such as mica. The clay coat layer 5 can be formed by applying such a ceramic together with an appropriate binder (for example, isocyanate-series, acrylic-series, vinyl chloride-series or epoxy-series binder) on the surface of the paper base material 4 and solidified by drying. The thickness of the clay coat layer 5 ranges, for example, from 5 to 30 µm.

It is important in the invention to form the clay coat layers 5 on both faces of the paper base material 4. This constitution makes it possible not only to relieve a decrease in the dimensional accuracy due to moisture absorption after punching but also to prevent troubles in the procedure of ultrasonic washing with pure water or washing water, etc.

As the material of the silicone layer (releasing agent layer) 6 to be formed on the surface of the clay coat layer 5, use may be made of, for example, a silicone-series releasing agent containing as the main component dimethyl polysiloxane of the addition reaction type, condensation reaction type, etc. The thickness of the silicone layer 6 ranges, for example, from 1 to 5 µm.

The above-described pressure-sensitive adhesive layer 3 is made of a pressure-sensitive adhesive (acrylic pressure-sensitive adhesive) which contains, as the main component, an alkyl (meth)acrylate-series copolymer comprising from 88 to 100% by weight, preferably from 90 to 97% by weight, of an alkyl (meth)acrylate carrying an alkyl group having 2 to 14 carbon atoms on average and from 0 to 12% by weight, preferably from 3 to 10% by weight, of a monoethylenic unsaturated monomer copolymerizable therewith.

Examples of the above-described alkyl (meth)acrylate include $C_{2-14}$ alkyl (meth)acrylates such as butyl acrylate, isooctyl acrylate, 2-ethylhexyl acrylate and isononyl acrylate. Either one of these $C_{2-14}$ alkyl (meth)acrylates or a combination of two or more thereof may be used. Examples of the above-described monoethylenic unsaturated monomer copolymerizable therewith include polar monomers, for example, unsaturated carboxylic acids such as acrylic acid, methacrylic acid and maleic acid and nitrogen-containing monomers such as acrylamide, N-vinyl pyrrolidone and acryloyl morpholine.

It is useful to add to the above-described pressure-sensitive adhesive a crosslinking agent, for example, a publicly known crosslinking agent such as an isocyanate-series compound or an epoxy-series compound to improve the holding properties of the pressure-sensitive adhesive, or to add a polyfunctional (meth)acrylate in case of performing photopolymerization. Examples of the polyfunctional (meth)acrylate include trimethylolpropane tri(meth)acrylate, pentaerythritol tetra(meth)acrylate, ethylene glycol di(meth)acrylate and 1,6-hexanediol di(meth)acrylate.

In case where the pressure-sensitive adhesive should have a high heat resistance, it is favorable to use a polymer obtained by UV irradiation. The above-described pressure-sensitive adhesive may further contain as optional ingredients various additives publicly known in the art such as tackifiers, plasticizers, softeners, fillers, pigments, dyes and antioxidants.

In the invention, the above-described pressure-sensitive adhesive (acrylic pressure-sensitive adhesive) contains at least 70%, preferably from 75 to 95% and still preferably from 80 to 90%, of solvent-insoluble matters. When the content of the solvent-insoluble matters is less than 70%, there arises self-adhesion at the cut surface after punching. In this case, moreover, the pressure-sensitive adhesive is stripped off by a cutting blade and the punching workability is seriously worsened. The content of the solvent-insoluble matters can be regulated by controlling the type and polymerization degree of the monomers constituting the pressure-sensitive adhesive and the type and content of the crosslinking agent.

The thickness of the pressure-sensitive adhesive layer 3 ranges, for example, from 20 to 130 µm.

As the base material 2 to be used in the adhesive sheet 11 shown in Fig. 2, use can be made of materials commonly employed as the base material of adhesive sheets, for example, synthetic resin films such as a polyester film, nonwoven fabric or a foam sheet. The thickness of the base material 2 generally ranges, for example, from 25 to 200 µm, though it may be appropriately selected depending on use.

The adhesive sheets according to the invention can be produced by, for example, applying a pressure-sensitive adhesive composition containing the acrylic pressure-sensitive adhesive on the silicone layer 6 of the release liner 7 to form the pressure-sensitive adhesive layer 3, or by applying a pressure-sensitive adhesive composition containing the acrylic pressure-sensitive adhesive on the base material 2, optionally crosslinking it by heating or polymerizing it by UV-irradiation to form the pressure-sensitive adhesive layer 3, and then covering the pressure-sensitive adhesive layer 3 with the release liner.

Although the adhesive sheets according to the invention are usable alone in adhering various articles, it is particularly favorable to use these adhesive sheets in pressure-sensitive adhesive tapes which are to be adhered to FPCs (flexible printed circuit boards) or reinforcing plates thereof and punched into desired shapes.

Next, the invention will be described in greater detail by reference to the following Examples. However, it is to be understood that the invention is not construed as being limited thereto. In these Examples, all parts are by weight.

EXAMPLE 1

90 parts of 2-ethylhexyl acrylate and 10 parts of acrylic acid were subjected to solution polymerization in 210 parts of ethyl acetate in the coexistence of 0.4 part of 2,2'-azobisisobutyronitirle by stirring at 60 to 80°C under nitrogen replacement to give a pressure-sensitive adhesive solution having a viscosity of about 120 P, a degree of polymerization of 99.2% and a solid matter content of 30.0% by weight. To 100 parts of this solution, 0.2 part of a polyfunctional epoxy-series crosslinking agent was added and mixed to give a pressure-sensitive adhesive composition.

On the other hand, clay coat layers, wherein silica was solidified with an ioscyanate-series binder, were formed on both faces of woodfree paper. On the surface of each clay coat layer, an addition polymerization type dimethyl siloxane polymer layer was formed to give a release liner. The above-described pressure-sensitive adhesive composition was applied onto the surface of this release liner and then dried in a hot-air dryer successively at 40°C for 5 minutes and at 130°C for additional 5 minutes to form a pressure-sensitive adhesive layer of 50 μm in thickness, thereby giving a pressure-sensitive adhesive tape.

EXAMPLE 2

A premix composed of 70 parts of isononyl acrylate, 20 parts of butyl acrylate, 10 parts of acrylic acid and 0.1 part of 2,2-dimethoxy-2-phenylacetone (photopolymerization initiator) was partly polymerized by exposing to UV light in a nitrogen atmosphere to give a syrup having a viscosity of about 300 P and being usable in coating. To 100 parts of this syrup, 0.2 part of trimethylolpropane triacrylate (crosslinking agent) was added and mixed to give a pressure-sensitive adhesive composition.

This composition was applied onto the surface of a release liner prepared as in Example 1 and photopolymerized by irradiating with UV light at 900 mJ/cm$^2$ from a high-pressure mercury lamp of 5 mW/cm$^2$ in photointensity under a nitrogen gas atmosphere. Then a pressure-sensitive adhesive layer of 50 μm in thickness was formed by drying in a hot-air dryer at 130°C for 5 minutes, thereby giving a pressure-sensitive adhesive tape.

EXAMPLE 3

A pressure-sensitive adhesive tape was obtained as in Example 2 but adding 0.15 part of trimethylolpropane triacrylate (crosslinking agent).

COMPARATIVE EXAMPLE 1

A pressure-sensitive adhesive tape was obtained as in Example 1 but using as a release liner a release liner consisting of glassine paper and silicone layers formed on both faces of the glassine paper.

COMPARATIVE EXAMPLE 2

A pressure-sensitive adhesive tape was obtained as in Example 1 but using as a release liner a release liner consisting of woodfree paper, polyethylene laminate layers formed on both faces of the paper and silicone layers formed on both faces of the laminate layers.

COMPARATIVE EXAMPLE 3

A pressure-sensitive adhesive tape was obtained as in Example 1 but using 0.07 part of the polyfunctional epoxy-series crosslinking agent.

The 180° peel adhesive strength, holding power, punchabilities (occurrence of damage on reinforcing plate, - occurrence of self-adhesion at cut surface, occurrence of adhesive removal by cutting blade), dimensional change ratio and washing properties (release liner conditions after washing) of each of the pressure-sensitive adhesive tapes produced in Examples 1 to 3 and Comparative Examples 1 to 3 were measured and evaluated by the following methods. Table 1 summarizes the results.

180° peel adhesive strength

A polyester film of 25 μm in thickness was adhered to one face of each of the pressure-sensitive adhesive tapes obtained in Examples and Comparative Examples and the release liner was peeled off to give a pressure-sensitive adhesive tape of 20 mm in width and 100 mm in length. Then this tape was adhered to a polished stainless plate by pressing with a 2 kg roller moved back and forth. After aging at 23°C under a relative humidity of 65% for 30 minutes, the 180° peel adhesive strength was measured with the use of a tensile tester operated at a speed of 300 mm/min at 23°C under a relative humidity of 65%.

Holding power

A polyimide film of 25 μm in thickness was adhered to one face of each of the pressure-sensitive adhesive tapes obtained in Examples and Comparative Examples and the release liner was peeled off to give a pressure-sensitive adhesive tape of 10 mm in width and 100 mm in length. Then this tape was adhered to a bakelite plate with a hand roller to give a width of 10 mm and a length of 20 mm. After loading a weight (1 kg) thereon in an atmosphere at 100°C, it was allowed to stand for 2 hours. Next, it was taken out and cooled by allowing to stand at room temperature for 1 hour followed by the measurement of the shift distance.

Content of solvent-insoluble matters

The pressure-sensitive adhesive of a sample tape (5 cm x 5 cm) was stripped off from the release liner, wrapped in a Teflon film (weight: A g) and the total weight (B g) was measured. Next, it was placed in a container which was then filled with ethylene acetate. After performing extraction at room temperature for 1 week, the Teflon film enclosing the above-described pressure-sensitive adhesive therein was transferred into an aluminum cup. After the Teflon film enclosing the pressure-sensitive adhesive therein was dried at 130°C for 2 hours, taken out and cooled for 20 minutes, the dry weight (C g) of the Teflon film having the pressure-sensitive adhesive enclosed therein was measured. Then the content of the solvent-insoluble matters was calculated in accordance with the following formula.

$$\text{Content of solvent-insoluble matters (\%)} = \{(C-A)/(B-A)\} \times 100.$$

Punchability 1 (occurrence of damage on reinforcing plate)

A glass epoxy plate (reinforcing plate) of 2 mm in thickness was adhered to one face of each pressure-sensitive adhesive tape obtained in Examples and Comparative Examples and punched from the release liner side with a press machine. Then cutouts and bores of the cut surface of the reinforcing plate were observed and evaluated in accordance with the following criteria.

○: No cutout or bore was observed on the cut surface of the reinforcing plate.
✕: Cutouts and bores were observed on the cut surface of the reinforcing plate.

Punchability 2 (occurrence of self-adhesion at cut surface)

A synthetic paper release liner was adhered on one face of each of the pressure-sensitive adhesive tapes obtained in Examples and Comparative Examples to give a double-lined pressure-sensitive adhesive tape. Then the tape was half-cut with a press machine from the side of the release liner shown in the Example or Comparative Example. The obtained sample was allowed to stand in an atmosphere at 60°C under a relative humidity of 90% for 1 week and the occurrence of self-adhesion at the cut surface was observed and evaluated in accordance with the following criteria.

○: No self-adhesion was observed at the cut surface of the tape.
✕: Self-adhesion was observed at the cut surface of the tape.

Punchability 3 (occurrence of adhesive removal by cutting blade)

A synthetic paper release liner was adhered on one face of each of the pressure-sensitive adhesive tapes obtained in Examples and Comparative Examples to give a double-lined pressure-sensitive adhesive tape. Then the tape was continuously half-cut with a sealing cutter from the side of the release liner shown in the Example or Comparative Example.

In this step, evaluation was made whether or not the adhesive adhered to the mold (cutting blade) of the sealing cutter and whether or not the adhesive was removed by the cutting blade during cutting, in accordance with the following criteria.

○: No adhesive removal by the cutting blade was observed.
✕: Adhesive removal by the cutting blase was observed.

Dimensional change ratio

Each of the pressure-sensitive adhesive tapes obtained in Examples and Comparative Examples was cut into a piece (200 x 200 mm) at 23°C under a relative humidity of 64%. The tape length at this point was referred to as $L_0$. Next, this tape piece was allowed to stand at 35°C under a relative humidity of 80% for 24 hours and then the tape length was measured. The tape length at this point was referred to as L. The dimensional change ratio was calculated in accordance with the following formula.

$$\text{Dimensional change ratio (\%)} = \{(L-L_0)/ L_0\}\times100.$$

Washing properties (release liner conditions)

An FPC was adhered to one face of each of the pressure-sensitive adhesive tapes obtained in Examples and Comparative Examples. After washing in an ultrasonic washing machine with warm water (57°C) for 5 minutes, the release liner conditions (wrinkles, tears, etc.) due to the moisture absorption by the release liner were observed and evaluated in accordance with the following criteria.

○: No change was observed, compared with unwashed state.
✕: Wrinkles and tears were observed.

Table 1

|  | Ex.1 | Ex.2 | Ex.3 | Comp. Ex.1 | Comp. Ex.2 | Comp. Ex.3 |
|---|---|---|---|---|---|---|
| 180° peel adhesive strength (gf/20mm) | 1100 | 1500 | 1700 | 1000 | 1200 | 1300 |
| Holding power (mm/2hr) | 0.1 | 0.1 | 0.3 | 0.1 | 0.1 | 1.5 |
| Solvent-insoluble matter content (%) | 83 | 84 | 72 | 82 | 83 | 63 |
| Punchability 1 | ○ | ○ | ○ | ○ | ✕ | ○ |
| Punchability 2 | ○ | ○ | ○ | ○ | ○ | ✕ |
| Punchability 3 | ○ | ○ | ○ | ○ | ○ | ✕ |
| Dimensional change ratio (%) | 0.3 | 0.3 | 0.3 | 1.0 | 0.3 | 0.3 |
| Washing properties | ○ | ○ | ○ | ✕ | ○ | ○ |

As Table 1 shows, the pressure-sensitive adhesive tapes of Examples 1 to 3 are each excellent in punchabilities and washing properties which are highly important factors in using these tapes for fixing FPCs and reinforcing plates thereof.
The adhesive sheets according to the invention have clay coat layers on a release liner and a pressure-sensitive adhesive layer made of a specific acrylic pressure-sensitive adhesive. Owing to this constitution, these adhesive sheets do not undergo self-adhesion with the passage of time at the cut surface in case of being punched alone. In case where these adhesive sheets are adhered to FPCs, reinforcing plates thereof, etc. and then punched, these sheets cause no damage on the cut surface of the reinforcing plates, etc. Moreover, breakage of the release liner in the washing procedure can be prevented.
While the invention has been described in detail and with reference to specific embodiments thereof, it will be apparent to one skilled in the art that various changes and modifications can be made therein without departing from the scope thereof.

**Claims**

**1.** Adhesive sheets having a laminated structure consisting of a release liner and a pressure-sensitive adhesive layer, wherein said release liner consists of a paper base material, clay coat layers provided on both faces of said paper base material and silicone layer(s) provided on one or both faces of said clay coat layers, a pressure-sensitive adhesive constituting said pressure-sensitive adhesive layer contains, as the main component, an alkyl (meth) acrylate-series copolymer comprising from 88 to 100% by weight of an alkyl (meth)acrylate carrying an alkyl group having 2 to 14 carbon atoms on average and from 0 to 12% by weight of a monoethylenic unsaturated monomer copolymerizable therewith, and said pressure-sensitive adhesive contains at least 70% of matters insoluble in ethyl acetate.

2. Adhesive sheets having pressure-sensitive adhesive layer(s) on one or both faces of a base material wherein said pressure-sensitive adhesive layer(s) are covered with release liner(s), wherein said release liner consists of a paper base material, clay coat layers provided on both faces of said paper base material and silicone layer(s) provided on one or both faces of said clay coat layers, a pressure-sensitive adhesive constituting said pressure-sensitive adhesive layer contains, as the main component, an alkyl (meth) acrylate-series copolymer comprising from 88 to 100% by weight of an alkyl (meth)acrylate carrying an alkyl group having 2 to 14 carbon atoms on average and from 0 to 12% by weight of a monoethylenic unsaturated monomer copolymerizable therewith, and said pressure-sensitive adhesive contains at least 70% of matters insoluble in ethyl acetate.

3. The adhesive sheets as claimed in claim 1 or 2 which are to be used in fixing flexible printed circuit boards or reinforcing plates thereof.

4. The adhesive sheets as claimed in claim 1 or 2, wherein said paper base material is selected from the group consisting of woodfree paper, glassine paper, Kraft paper and Krupack paper.

5. The adhesive sheets as claimed in claim 1 or 2, wherein the thickness of said paper base material ranges from 60 to 130 $\mu$m.

6. The adhesive sheets as claimed in claim 1 or 2, wherein said clay coat layer comprises ceramics and a binder.

7. The adhesive sheets as claimed in claim 6, wherein said ceramic is selected from the group consisting of inorganic oxides, hydroxides, carbonates, sulfates, silicates, titanates, borates, carbides, nitrides, borides and carbon.

8. The adhesive sheets as claimed in claim 7, wherein the ceramic is selected from the group consisting of silica, alumina and mica.

9. The adhesive sheets as claimed in claim 6, wherein said binder is selected from the group consisting of isocyanate-series binder, acrylic-series binder, vinyl chloride-series binder and epoxy-series binder.

10. The adhesive sheets as claimed in claim 1 or 2, wherein the thickness of said clay coat layer ranges from 5 to 30 $\mu$m.

11. The adhesive sheets as claimed in claim 1 or 2, wherein said alkyl (meth)acrylate is either one of $C_{2-14}$ alkyl (meth) acrylates or a combination of two or more thereof.

12. The adhesive sheets as claimed in claim 11, wherein said $C_{2-14}$ alkyl (meth)acrylates is selected from the group consisting of butyl acrylate, isooctyl acrylate, 2-ethylhexyl acrylate and isononyl acrylate.

13. The adhesive sheets as claimed in claim 1 or 2, wherein said monoethylenic unsaturated monomer copolymerizable with alkyl (meth)acrylate is a polar monomer.

14. The adhesive sheets as claimed in claim 13, wherein said monoethylenic unsaturated monomer is selected from the group consisting of unsaturated carboxylic acids and nitrogen-containing monomers.

15. The adhesive sheets as claimed in claim 14, wherein said monoethylenic unsaturated monomer is selected from the group consisting of acrylic acid, methacrylic acid, maleic acid, acrylamide, N-vinyl pyrrolidone and acryloyl morpholine.

16. The adhesive sheets as claimed in claim 1 or 2, wherein said pressure-sensitive adhesive contains, as the main component, an alkyl (meth)acrylate-series copolymer comprising from 90 to 97% by weight of an alkyl (meth) acrylate carrying an alkyl group having 2 to 14 carbon atoms on average and from 3 to 10% by weight of a monoethylenic unsaturated monomer copolymerizable therewith.

17. The adhesive sheets as claimed in claim 1 or 2, wherein said pressure-sensitive adhesive contains from 75 to 95% of matters insoluble in methyl acetate.

**18.** The adhesive sheets as claimed in claim 17, wherein said pressure-sensitive adhesive contains from 80 to 90% of matters insoluble in ethyl acetate.

**19.** The adhesive sheets as claimed in claim 1 or 2, wherein the thickness of said pressure-sensitive adhesive layer ranges from 20 to 130 $\mu$m.


**Patentansprüche**

**1.** Klebefolien mit einer laminierten Struktur, bestehend aus einem Ablösepapier und einer druckempfindlichen Klebschicht, worin das Ablösepapier aus einem Papiergrundmaterial, Tonüberzugsschichten, die auf beiden Oberflächen des Papiergrundmaterials angeordnet sind, und einer oder mehreren Silikonschichten, die auf einer oder beiden Oberflächen der Tonüberzugsschichten angeordnet sind, einem druckempfindlichen Kleber, welcher die druckempfindliche Klebschicht bildet und als Hauptkomponente ein Copolymer der Alkyl(meth)acrylat-Reihe, umfassend 88 bis 100 Gew.-% eines Alkyl(meth)acrylats, das eine Alkylgruppe mit im Durchschnitt 2 bis 14 Kohlenstoffatomen trägt, und 0 bis 12 Gew.-% eines monoethylenisch ungesättigten, damit copolymerisierbaren Monomers enthält, und der druckempfindliche Kleber wenigstens 70 % in Ethylacetat unlösliche Bestandteile enthält.

**2.** Klebefolien mit einer oder mehreren druckempfindlichen Klebschichten auf einer oder beiden Oberflächen eines Grundmaterials, worin die druckempfindliche(n) Klebschicht(en) mit einem oder mehreren Ablösepapieren bedeckt sind, worin das Ablösepapier besteht aus einem Papiergrundmaterial, Tonüberzugsschichten, die auf beiden Oberflächen des Papiergrundmaterials vorgesehen sind, und einer oder mehreren Silikonschichten, die auf einer oder beiden Oberflächen der Tonüberzugsschichten vorgesehen sind, einem druckempfindlichen Kleber, welcher die druckempfindliche Klebschicht bildet und als Hauptkomponente ein Copolymer der Alkyl(meth)acrylat-Reihe, umfassend 88 bis 100 Gew.-% eines Alkyl(meth)-acrylats, das eine Alkylgruppe mit im Durchschnitt 2 bis 14 Kohlenstoffatomen trägt, und 0 bis 12 Gew.-% eines ethylenisch ungesättigten, damit copolymerisierbaren Monomers enthält, und der druckempfindliche Kleber wenigstens 70 % in Ethylacetat unlösliche Bestandteilen enthält.

**3.** Klebefolien wie in Anspruch 1 oder 2 beansprucht, die beim Fixieren von flexiblen Leiterplatten oder Verstärkungsplatten hierfür zu verwenden sind.

**4.** Klebefolien wie in Anspruch 1 oder 2 beansprucht, worin das Papiergrundmaterial ausgewählt ist aus der Gruppe bestehend aus holzfreiem Papier, Pergaminpapier, Kraftpapier und Krupackpapier.

**5.** Klebefolien wie in Anspruch 1 oder 2 beansprucht, worin die Dicke des Papiergrundmaterials im Bereich von 60 bis 130 $\mu$m liegt.

**6.** Klebefolien wie in Anspruch 1 oder 2 beansprucht, worin die Tonüberzugsschicht keramische Materialien und ein Bindemittel umfasst.

**7.** Klebefolien wie in Anspruch 6 beansprucht, worin das keramische Material ausgewählt ist aus der Gruppe bestehend aus anorganischen Oxiden, Hydroxiden, Carbonaten, Sulfaten, Silikaten, Titanaten, Boraten, Carbiden, Nitriden, Boriden und Kohlenstoff.

**8.** Klebefolien wie in Anspruch 7 beansprucht, worin das keramische Material ausgewählt ist aus der Gruppe bestehend aus Siliziumdioxid, Aluminiumoxid und Glimmer.

**9.** Klebefolien wie in Anspruch 6 beansprucht, worin das Bindemittel ausgewählt ist aus der Gruppe bestehend aus Bindemitteln der Isocyanatreihe, Bindemitteln der Acrylreihe, Bindemitteln der Vinylchloridreihe und Bindemitteln der Epoxyreihe.

**10.** Klebefolien wie in Anspruch 1 oder 2 beansprucht, worin die Dicke der Tonüberzugsschicht im Bereich von 5 bis 30 $\mu$m liegt.

**11.** Klebefolien wie in Anspruch 1 oder 2 beansprucht, worin das Alkyl(meth)acrylat entweder eines von $C_{2-14}$-Alkyl(meth)acrylaten oder eine Kombination von zwei oder mehreren davon ist.

**12.** Klebefolien wie in Anspruch 11 beansprucht, worin das $C_{2-14}$-Alkyl(meth)acrylat ausgewählt ist aus der Gruppe bestehend aus Butylacrylat, Isooctylacrylat, 2-Ethylhexylacrylat und Isononylacrylat.

13. Klebefolien wie in Anspruch 1 oder 2 beansprucht, worin das monoethylenisch ungesättigte mit Alkyl(meth)acrylat copolymerisierbare Monomer ein polares Monomer ist.

14. Klebefolien wie in Anspruch 13 beansprucht, worin das monoethylenisch ungesättigte Monomer ausgewählt ist aus der Gruppe bestehend aus ungesättigten Carbonsäuren und Stickstoff enthaltenden Monomeren.

15. Klebefolien wie in Anspruch 14 beansprucht, worin das monoethylenisch ungesättigte Monomer ausgewählt ist aus der Gruppe bestehend aus Acrylsäure, Methacrylsäure, Maleinsäure, Acrylamid, N-Vinylpyrrolidon und Acryloylmorpholin.

16. Klebefolien wie in Anspruch 1 oder 2 beansprucht, worin der druckempfindliche Kleber als Hauptkomponente ein Copolymer der Alkyl(meth)acrylat-Reihe enthält, umfassend 90 bis 97 Gew.-% eines Alkyl(meth)acrylats, das eine Alkylgruppe mit im Durchschnitt 2 bis 14 Kohlenstoffatomen trägt, und 3 bis 10 Gew.-% eines monoethylenisch ungesättigten, damit copolymerisierbaren Monomers.

17. Klebefolien wie in Anspruch 1 oder 2 beansprucht, worin der druckempfindliche Kleber 75 bis 95 Gew.-% in Ethylacetat unlösliche Bestandteile enthält.

18. Klebefolien wie in Anspruch 17 beansprucht, worin der druckempfindliche Kleber 80 bis 90 % in Ethylacetat unlösliche Bestandteile enthält.

19. Klebefolien wie in Anspruch 1 oder 2 beansprucht, worin die Dicke der druckempfindlichen Klebschicht im Bereich von 20 bis 130 μm liegt.

**Revendications**

1. Feuilles adhésives ayant une structure laminée constituée d'une doublure antiadhésive et d'une couche auto-adhésive, dans lesquelles ladite doublure antiadhésive est constituée d'un matériau à base de papier, de couches de revêtement de kaolin fournies sur les deux faces dudit matériau à base de papier et d'une (de) couche(s) de silicone fournie sur l'une ou sur les deux face(s) desdites couches de revêtement de kaolin, un adhésif auto-collant constituant ladite couche auto-adhésive contient, comme composant principal, un copolymère de série de (méth) acrylate d'alkyle comprenant de 88 à 100 % en poids d'un (méth)acrylate d'alkyle comportant un groupe alkyle ayant de 2 à 14 atomes de carbone en moyenne et de 0 à 12 % en poids d'un monomère monoéthylénique insaturé copolymérisable avec celui-ci, et ledit adhésif auto-collant contient au moins 70 % de matières insolubles dans l'acétate d'éthyle.

2. Feuilles adhésives ayant une (des) couche(s) autoadhésive(s) sur l'une ou les deux faces d'un matériau de base dans lesquelles ladite (lesdites) couche(s) auto-adhésive(s) est (sont) couverte(s) avec une (des) doublure(s) antiadhésive(s), dans lesquelles ladite doublure antiadhésive est constituée d'un matériau à base de papier, de couches de revêtement de kaolin fournies sur les deux faces dudit matériau à base de papier et d'une (de) couche (s) de silicone fournie(s) sur l'une ou sur les deux face(s) desdites couches de revêtement de kaolin, un adhésif auto-collant constituant ladite couche auto-adhésive contient, comme composant principal, un copolymère de série de (méth)acrylate d'alkyle comprenant de 88 à 100 % en poids d'un (méth)acrylate d'alkyle comportant un groupe alkyle ayant de 2 à 14 atomes de carbone en moyenne et de 0 à 12 % en poids d'un monomère monoéthylénique insaturé copolymérisable avec celui-ci, et ledit adhésif auto-collant contient au moins 70 % de matières insolubles dans l'acétate d'éthyle.

3. Feuilles adhésives selon les revendications 1 ou 2, destinées à être utilisées pour la fixation des cartes flexibles de circuit imprimé ou pour renforcer des plaques de ceux-ci.

4. Feuilles adhésives selon la revendication 1 ou 2, dans lesquelles ledit matériau à base de papier est choisi dans le groupe constitué par le papier sans bois, le papier cristal, le papier kraft et le papier Krupack.

5. Feuilles adhésives selon la revendication 1 ou 2, dans lesquelles l'épaisseur dudit matériau à base de papier est comprise dans la plage allant de 60 à 130 μm.

**6.** Feuilles adhésives selon la revendication 1 ou 2, dans lesquelles ladite couche de revêtement de kaolin comprend des céramiques et un liant.

**7.** Feuilles adhésives selon la revendication 6, dans lesquelles ladite céramique est choisie dans le groupe constitué des oxydes inorganiques, des hydroxydes, des carbonates, des sulfates, des silicates, des titanates, des borates, des carbures, des nitrures, des borures et du carbone.

**8.** Feuilles adhésives selon la revendication 7, dans lesquelles la céramique est choisie dans le groupe constitué de la silice, de l'alumine et du mica.

**9.** Feuilles adhésives selon la revendication 6, dans lesquelles ledit liant est choisi dans le groupe constitué d'un liant de série d'isocyanate, d'un liant de série d'acrylique, d'un liant de série de chlorure de vinyle et d'un liant de série d'époxyde.

**10.** Feuilles adhésives selon la revendication 1 ou 2, dans lesquelles l'épaisseur de ladite couche de revêtement de kaolin est comprise entre 5 et 30 μm.

**11.** Feuilles adhésives selon la revendication 1 ou 2, dans lesquelles ledit (méth)acrylate d'alkyle est soit l'un des (méth)acrylates d'alkyles en $C_{2-14}$ soit une combinaison de deux ou plusieurs de ceux-ci.

**12.** Feuilles adhésives selon la revendication 11, dans lesquelles lesdits (méth)acrylates d'alkyle en $C_{2-14}$ sont choisis dans le groupe constitué de l'acrylate de butyle, de l'acrylate d'isooctyl, de l'acrylate de 2-éthylhexyl et de l'acrylate d'isononyl.

**13.** Feuilles adhésives selon la revendication 1 ou 2, dans lesquelles ledit monomère monoéthylénique insaturé copolymérisable avec le (méth)acrylate d'alkyle est un monomère polaire.

**14.** Feuilles adhésives selon la revendication 13, dans lesquelles ledit monomère monoéthylénique insaturé est choisi dans le groupe constitué des acides carboxyliques insaturés et des monomères contenant de l'azote.

**15.** Feuilles adhésives selon la revendication 14, dans lesquelles ledit monomère monoéthylénique insaturé est choisi dans le groupe constitué de l'acide acrylique, de l'acide méthacrylique, de l'acide maléique, de l'acrylamide, de la N-vinyle pyrrolidone et de l'acryloyl morpholine.

**16.** Feuilles adhésives selon la revendication 1 ou 2, dans lesquelles ledit adhésif auto-collant contient, comme composant principal, un copolymère constitué d'une série de (méth)acrylates d'alkyle comprenant entre 90 et 97 % en poids d'un (méth)acrylate d'alkyle comportant un groupe alkyle ayant de 2 à 14 atomes de carbone en moyenne et de 3 à 10 % en poids d'un monomère monoéthylénique insaturé copolymérisable avec celui-ci.

**17.** Feuilles adhésives selon la revendication 1 ou 2, dans lesquelles ledit adhésif auto-collant contient de 75 à 95 % de matières insolubles dans l'acétate d'éthyle.

**18.** Feuilles adhésives selon la revendication 17, dans lesquelles ledit adhêsif auto-collant contient de 80 à 90 % de matières insolubles dans l'acétate d'éthyle.

**19.** Feuilles adhésives selon la revendication 1 ou 2, dans lesquelles l'épaisseur de ladite couche auto-adhésive est située entre 20 et 130 μm.

# FIG. 1

# FIG. 2